# FASCICULE DE BREVET EUROPEEN

(11) **EP 2 681 912 B1**
(45) Date de publication et mention de la délivrance du brevet: **01.09.2021**
(21) Numéro de dépôt: 12712305.7
(22) Date de dépôt: 01.03.2012
(51) Int. Cl.: H04N 7/24, H03M 7/30, H04L 29/06, H04N 21/643

(54) **CODAGE DE DONNÉES SANS PERTE POUR COMMUNICATION BIDIRECTIONNELLE DANS UNE SESSION COLLABORATIVE D'ÉCHANGE DE CONTENU MULTIMÉDIA**
VERLUSTFREIE DATENCODIERUNG FÜR BIDIREKTIONALE KOMMUNIKATION IN EINER KOLLABORATIVEN SITZUNG EINES MULTIMEDIA-INHALTSAUSTAUSCHES
LOSSLESS DATA CODING FOR BIDIRECTIONAL COMMUNICATION IN A COLLABORATIVE SESSION OF MULTIMEDIA CONTENT EXCHANGE

(30) Priorité: 03.03.2011 FR 1151727
(43) Date de publication de la demande: 08.01.2014
(73) Titulaire: Association pour la Recherche et le Développement des Méthodes et Processus Industriels "ARMINES", 75006 Paris (FR); Prologue, 91940 Les Ulis (FR); Institut Mines-Telecom, 75013 Paris (FR)
(72) Inventeur: MARSHALL, Iain, James, 77140 St Pierre Les Nemours (FR); MITREA, Mihai, Petru, 91600 Savigny sur Orge (FR); JOVESKI, Bojan, 75012 Paris (FR); GARDENGHI, Ludovico, 94240 L'Hay Les Roses (FR); PRETEUX, Françoise, Jacqueline, 75013 Paris (FR)
(74) Mandataire: Cabinet Beau de Loménie
(86) Numéro de dépôt international: PCT/FR2012/050428
(87) Numéro de publication internationale: WO 2012/117206

(56) Documents cités:
- EP-A1- 1 376 878
- WO-A2-2005/011175
- WO-A2-2008/004147
- US-A- 6 088 699
- US-A1- 2005 185 677
- SAINT-ANDRE CISCO P: "Extensible Messaging and Presence Protocol (XMPP): Core; draft-ietf-xmpp-3920bis-14.txt", EXTENSIBLE MESSAGING AND PRESENCE PROTOCOL (XMPP): CORE; DRAFT-IETF-XMPP-3920BIS-14.TXT, INTERNET ENGINEERING TASK FORCE, IETF; STANDARDWORKINGDRAFT, INTERNET SOCIETY (ISOC) 4, RUE DES FALAISES CH- 1205 GENEVA, SWITZERLAND, no. 14, 8 septembre 2010 (2010-09-08), pages 1-183, XP015071085,
- PRICE SIEMENS/ROKE MANOR C BORMANN TZI/UNI BREMEN J CHRISTOFFERSSON H HANNU ERICSSON Z LIU NOKIA J ROSENBERG DYNAMICSOFT R: "Signaling Compression (SigComp); rfc3320.txt", IETF STANDARD, INTERNET ENGINEERING TASK FORCE, IETF, CH, 1 janvier 2003 (2003-01-01), XP015009190, ISSN: 0000-0003
- WEIHAI LI ET AL: "Dynamic Dictionary Design for SIP Signaling Compression", COMPUTER SCIENCE AND INFORMATION ENGINEERING, 2009 WRI WORLD CONGRESS ON, IEEE, PISCATAWAY, NJ, USA, 31 March 2009 (2009-03-31), pages 448-451, XP031494649, ISBN: 978-0-7695-3507-4
- HANNU J CHRISTOFFERSSON ERICSSON S FORSGREN K-C LEUNG TEXAS TECH UNIVERSITY Z LIU NOKIA R PRICE SIEMENS/ROKE MANOR H: "Signaling Compression (SigComp) - Extended Operations; rfc3321.txt", SIGNALING COMPRESSION (SIGCOMP) - EXTENDED OPERATIONS; RFC3321.TXT, INTERNET ENGINEERING TASK FORCE, IETF; STANDARD, INTERNET SOCIETY (ISOC) 4, RUE DES FALAISES CH- 1205 GENEVA, SWITZERLAND, 1 January 2003 (2003-01-01), XP015009191,

## Description

### Arrière-plan de l'invention

La présente invention se situe dans le domaine du codage de données sans perte.

Elle s'applique plus particulièrement mais de façon non limitative pour le codage sans perte des données de transport utilisées pour le contrôle de flux multimédia conforme à un standard de la famille MPEG.

Dans l'état actuel de la technique, les standards MPEG-4 FF (File Format) et MPEG-2 TS (Transport Stream) offrent des solutions pour le formatage et le transport de contenus multimédias, notamment en termes de codage binaire du flux vidéo, du flux audio et de représentation de la scène.

Ce standard est bien adapté pour une utilisation statique du contenu multimédia dans laquelle l'interactivité entre le serveur de contenu et le client restituant le contenu est très réduite.

Mais les solutions connues à ce jour sont mal adaptées aux applications fortement interactives, et a fortiori aux applications collaboratives, le poids des données de transport des informations collaboratives pouvant être excessivement lourd.

L'invention vise un mécanisme de codage qui permet notamment de réduire considérablement le volume de ces données.

Le document WO2008004147, ainsi que le document WEIHAI LI ET AL: "Dynamic Dictionary Design for SIP Signaling Compression", COMPUTER SCIENCE AND INFORMATION ENGINEERING, 2009 WRI WORLD CONGRESS ON, IEEE, PISCATAWAY, NJ, USA, 31 mars 2009 (2009-03-31), pages 448-451, décrivent l'utilisation de la technique Sigcomp comprenant la mise en oeuvre de dictionnaires partagés dans le cadre de sessions SIP.

Le document US6088699 décrit la génération de dictionnaires partagés par l'échange de messages incluant des sous-parties, dont l'une comprend des données liées au dictionnaire.

Le document US2005185677 décrit la génération et la maintenance d'un dictionnaire partagé pour la compression de messages. Le dictionnaire est implémenté sous forme d'une zone mémoire de type FIFO.

### Objet et résumé de l'invention

Plus précisément et selon un premier aspect, l'invention concerne un procédé de codage sans perte de messages de collaboration conformes au protocole XMPP mis en œuvre par un équipement émetteur, en communication bidirectionnelle avec au moins un équipement récepteur dans une session collaborative d'échange de contenu multimédia. Ce procédé comporte:
- au cours de ladite session, au moins :
   - une étape d'échange, avec le ou les équipements récepteurs, au moins un attribut d'un message de collaboration susceptible d'être utilisé dans cette session et d'un index associé à cet attribut, l'attribut et son index étant utilisés par ces équipements pour mettre à jour un dictionnaire partagé d'attributs indexés, ce dictionnaire étant mémorisé par chacun de ces équipements pendant toute la durée de la session ;
   - une étape de substitution, dans un message de collaboration destiné à être envoyé à ou aux équipements récepteurs, d'au moins un attribut par son index dans le dictionnaire partagé ;
   - une étape d'envoi du message de collaboration à ou aux équipements récepteurs ; et
- une étape de destruction du dictionnaire partagé à la fin de la session.

Corrélativement, l'invention concerne aussi un dispositif de codage sans perte de messages de collaboration conformes au protocole XMPP pouvant être incorporé dans un équipement émetteur apte à établir une communication bidirectionnelle avec au moins un équipement récepteur dans une session collaborative d'échange de contenu multimédia. Ce dispositif comporte :
- des moyens pour échanger avec le ou les équipements récepteurs, au cours de la session, au moins un attribut d'un message de collaboration susceptible d'être utilisé dans la session et un index associé à cet attribut, l'attribut et son index étant utilisés par ces équipements pour mettre à jour un dictionnaire partagé d'attributs indexés ;
- des moyens pour mémoriser le dictionnaire partagé pendant toute la durée de la session ;
- des moyens de substitution, dans un message de collaboration destiné à être envoyé à ou aux équipements récepteurs, d'au moins un attribut par son index dans le dictionnaire partagé ;
- des moyens d'envoi du message de collaboration à ou aux équipements récepteurs ; et
- des moyens de destruction du dictionnaire partagé à la fin de la session.

Selon un deuxième aspect, l'invention vise également un procédé de décodage sans perte de messages de collaboration conformes au protocole XMPP mis en œuvre par un équipement récepteur, en communication bidirectionnelle avec au moins un équipement émetteur dans une session collaborative d'échange de contenu multimédia, ce procédé comportant :
- au cours de ladite session, au moins :
   - une étape d'échange, avec le ou les équipements récepteurs, d'au moins un attribut d'un message de collaboration susceptible d'être utilisé dans la session et d'un index associé à cet attribut, l'attribut et son index étant utilisés par ces équipements pour mettre à jour un dictionnaire partagé d'attributs indexés, ce dictionnaire étant mémorisé par chacun des équipements pendant toute la durée de la session ; et
   - une étape de réception d'un message de collaboration émis par un des équipements émetteurs comportant au moins un index ;
   - une étape de substitution, dans ce message de collaboration du chacun de ces index par l'attribut auquel il est associé dans le dictionnaire partagé ; et
- une étape de destruction du dictionnaire partagé à la fin de la session.

Corrélativement, l'invention vise aussi un dispositif de décodage sans perte de messages de collaboration conformes au protocole XMPP pouvant être incorporé dans un équipement récepteur apte à établir une communication bidirectionnelle avec au moins un équipement émetteur dans une session collaborative d'échange de contenu multimédia, ce dispositif comportant :
- des moyens pour échanger avec le ou avec les équipements émetteur, au cours de ladite session, au moins un attribut d'un message de collaboration susceptible d'être utilisé dans la session et d'un index associé à cet attribut, l'attribut et son index étant utilisés par ces équipements pour mettre à jour un dictionnaire partagé d'attributs indexés ;
- des moyens de réception d'un message de collaboration émis par un de ces équipements émetteurs comportant au moins un index ;
- des moyens de substitution, dans le message de collaboration de chacun des index par l'attribut auquel il est associé dans le dictionnaire partagé ; et
- des moyens de destruction du dictionnaire partagé à la fin de la session.

Ainsi, et d'une façon générale, l'invention propose de substituer des attributs présents dans des messages de collaboration par des index associés à ces attributs dans un dictionnaire partagé entre l'émetteur et les récepteurs de ce message.

Conformément à l'invention, les messages de collaboration sont des messages échangés entre un émetteur et un récepteur, une fois que ceux-ci ont été localisés, par exemple en utilisant le protocole SIP.

Il est important de noter que les messages de collaboration codés par l'invention sont par natures imprédictibles, au contraire des messages échangés au cours de la phase préliminaire à l'invention, dans le cadre par exemple du protocole SIP.

L'invention peut être mise en œuvre en complément ou non d'un autre mécanisme de compression du protocole SIP.

Le partage des données de collaboration conformément à l'invention requiert une extension du codeur pour la production des données codées et du décodeur pour leur exploitation.

Le fait de remplacer un attribut par un index peut être avantageusement utilisé pour crypter les attributs, les index étant par exemple constitués par un haché de ces attributs.

Conformément à l'invention, la taille d'un attribut est supérieure à la taille de son index dans le dictionnaire partagé. Le procédé de codage selon l'invention est alors un procédé de compression de données sans perte.

Dans un mode particulier de réalisation, la taille du dictionnaire partagé permet de déterminer le nombre de bits requis pour les index des attributs suivants partagés entre l'émetteur et le récepteur.

Dans un mode particulier de réalisation de l'invention, le contenu multimédia est conforme à un standard de la famille MPEG.

L'invention permet ainsi un procédé de codage sans perte des données de transport utilisées pour le contrôle des flux de communication MPEG. Elle offre un mécanisme de compression des données de transport particulièrement efficace dans le contexte des applications bidirectionnelles collaboratives pour lesquelles un nombre assez limité d'attributs est échangé un nombre très important de fois entre les différents dispositifs participant à la session.

En particulier, l'invention offre un taux de compression particulièrement important pour des applications dans lesquelles des informations des messages de présence ou de notification d'état sont régulièrement échangées entre des clients et un serveur central.

On rappelle que pour des applications de collaboration impliquant N participants connectés à une même session de collaboration, N*(N-1) messages de présence sont régulièrement échangés entre les participants, par exemple toutes les deux ou trois secondes. Ainsi pour 10,000 utilisateurs connectés et des messages de présence de 100 octets, 10Gb sont échangés à chaque intervalle de temps.

Pour de telles applications, l'invention permet de réduire ce volume d'un facteur 10 environ (1Gb).

Ce taux de compression peut être obtenu grâce à l'invention, du fait du partage pendant toute la session des index associés aux informations les plus couteuses, par exemple les identifiants de l'espace de collaboration, noms de domaines, identifiants des participants, ...

Le dictionnaire partagé est avantageusement détruit à la fin de la session pour ne pas encombrer inutilement la mémoire des différents équipements.

Conformément à l'invention, le contenu du dictionnaire partagé entre le codeur et le décodeur augmente au besoin pendant le déroulement de la session. Cette caractéristique offre avantageusement une solution très flexible en termes de complexité.

Dans un mode particulier de réalisation de l'invention, la session met en œuvre le protocole RTP pour l'échange des données multimédia et le protocole RTSP pour l'initialisation et le contrôle de cet échange.

Dans ce contexte, l'invention permet de réduire la charge utile additionnelle nécessaire au transport de des données de collaboration à son strict minimum et donc d'optimiser l'utilisation de la bande passante pour le transport du contenu multimédia à proprement parler (données audio, vidéo et de représentation de la scène).

Dans un mode particulier de mise en œuvre de l'invention chaque équipement est apte à mettre en œuvre le procédé de codage et le procédé de décodage conformes à l'invention.

Par conséquent, l'invention vise aussi un dispositif de communication comportant un dispositif de codage selon tel que mentionné ci-dessus et un dispositif de décodage tel que mentionné ci-dessus.

L'invention vise aussi un équipement de communication comportant un dispositif tel que mentionné ci-dessus.

L'invention vise aussi un système de collaboration comportant au moins deux équipements tels que mentionnés ci-dessus.

Conformément à l'invention, la session collaborative est conforme au standard XMPP.

Dans un mode particulier de réalisation de l'invention, le procédé de codage et le procédé de décodage selon l'invention sont mis en œuvre par des programmes d'ordinateur.

Par conséquent, l'invention vise aussi un programme d'ordinateur sur un support d'informations, ce programme étant susceptible d'être mis en œuvre par un ordinateur, ce programme comportant des instructions adaptées à la mise en œuvre des étapes d'un procédé de codage et/ou d'un procédé de décodage tels que mentionné ci-dessus.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'informations lisible par un ordinateur, et comportant des instructions d'un programme d'ordinateur tel que mentionné ci-dessus.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette (floppy disc) ou un disque dur.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé en question.

### Brève description des dessins

D'autres caractéristiques et avantages de la présente invention ressortiront de la description faite ci-dessous en référence aux dessins et aux annexes qui en illustrent un exemple de réalisation dépourvu de tout caractère limitatif. Sur les figures :
- la figure 1 représente de façon schématique un exemple de système de collaboration conforme à l'invention ; et
- la figure 2 représente sous forme d'organigrammes les principales étapes d'un procédé de codage et d'un procédé de décodage conformes à un mode particulier de réalisation de l'invention.

### Description détaillée d'un mode de réalisation

En premier lieu, et en référence aux Annexes 1 et 2, nous allons détailler un exemple de codage pouvant être utilisé dans l'invention.

Dans l'exemple de réalisation décrit ici, les messages de collaboration sont décrits en utilisant le standard XMPP (Extensible Message and Presence Protocol) ; l'encapsulation et le transport des flux multimédias utilisé est conforme au format MPEG.

On rappelle que l'invention est mise en œuvre, une fois que les émetteurs et les récepteurs ont été localisés, par exemple via le protocole SIP.

Conformément à l'invention, les messages de collaboration codés par l'invention peuvent être de 4 natures.

Les messages de collaboration d'une première nature sont des messages d'énumération utilisés pour la mise à jour du dictionnaire partagé au cours de la session.

Les messages de collaboration des trois autres natures sont, dans cet exemple :
- les messages CIP spécifiant un état de présence de l'équipement émetteur ;
- les messages CIM comportant des informations destinées à l'équipement récepteur ; et
- les messages CIQ comportant des métadonnées d'administration ou de contrôle d'un système de collaboration dans lequel la session est mise en œuvre.

Pour les messages de collaboration autres que les messages d'énumération, on utilise, dans cet exemple, les attributs suivants:
- « Type » : qui définit la sémantique de la nature et qui est codé avec une valeur prédéterminée pour chacun des types;
- « To » : qui définit le destinataire du message;
- « From » : qui définit l'émetteur du message; et
- « ID » qui définit une information permettant l'identification du message par l'application collaborative.

Dans le mode particulier de réalisation de l'invention décrit ici, le message de collaboration comporte :
- un champ représentatif de la nature du message; et, pour les messages de collaboration autres que les messages d'énumération :
- un attribut représentatif de la sémantique de la nature du message ; et
- un élément binaire représentatif de la présence ou non d'un attribut dans ledit message, suivi, lorsque l'attribut est présent, d'un corps comportant l'index associé à l'attribut dans le dictionnaire partagé.

Dans le mode de réalisation décrit ici, et comme représenté à l'Annexe 1, le codage des informations de collaboration utilise un champ de deux bits CIUNature pour décrire la nature du message de collaboration. Plus précisément:
- 00 représente un message d'énumération utilisé pour l'échange des données du dictionnaire partagé ETU;
- 01 représente un message CIP;
- 10 représente un message CIM ; et
- 11 représente un message CIQ.

Pour les messages CIP, CIM et CIQ, le champ de description CIUNature sur deux bits est suivi par :
- un élément CIUType représentatif de la sémantique de la nature du message; et, pour chacun des attributs TO, FROM, ID, un élément binaire représentatif de la présence ou non de cet attribut dans le message, suivi, lorsque l'attribut est présent, d'un corps comportant l'index associé à cet attribut dans le dictionnaire partagé ETU.

Lorsqu'il est présent, le corps est codé en utilisant les index du dictionnaire partagé pour décrire les différents attributs, comme illustré sur un exemple à l'annexe 1.

Plus précisément, dans cet exemple, le corps comporte:
- un champ ETI fournissant l'index du dictionnaire partagé pour décrire le du nom de l'élément principal ;
- une collection d'attributs associés à cet élément principal et pour chaque attribut, signalé en avance par un bit, une paire d'index du dictionnaire partagé représentant dans l'ordre leur nom et leur valeur ;
- un contenu, de type texte, signalé par un bit et composé d'une chaîne de caractères ASCII terminée par un octet à zéro ; et
- une collection d'éléments signalés en avance par leur bit de présence suivi par leur description, récursive, comme pour l'élément principal.

On considère à titre d'exemple le message, de présence XMPP suivant, ce message étant destiné à être transmis par un client après une phase d'initialisation.
<presence from= 'john@somewhere.com' to='host@collaborator.com' />

La longueur de ce message est 64 octets soit 512 bits.

Conformément à l'invention, ce message peut être transmis, tout au cours d'une session, par un équipement émetteur à un équipement récepteur en substituant deux attributs TO et FROM par deux index partagés par ces équipements pendant la durée de la session.

Ainsi, en appliquant le codage de l'annexe 1, on obtient :
ETU john@somewhere.com
   2 bits de code 00 représentatifs d'une commande d'énumération; et
   8 bits pour chaque octet des chaînes de caractères
   1 octet de terminaison NULL, soit 19 octets au total.
      L'index 00 obtenu implicitement sera utilisé suite à l'échange de cet ETU en substitution de ce premier attribut.
ETU host@collaborator.com
   2 bits de code 00 représentatifs d'une commande d'énumération; et
   8 bits pour chaque octet des chaînes de caractères
   1 octet de terminaison NULL, soit 22 octets au total.
      L'index 01 obtenu implicitement sera utilisé suite à l'échange de cet ETU en substitution de ce deuxième attribut.

Le volume de données échangées pour la mise à jour du dictionnaire partagé est donc de 345 bits.
- Ensuite, ce message de présence peut être codé en utilisant seulement 14 bits qui se décomposent comme suit :
   - 2 bits CIP
   - 3 bits pour coder le type (valeur 000 par défaut)
   - 1 bit et 2 bits 00 pour l'attribut TO
   - 1 bit et 2 bits 01 pout l'attribut FROM
   - 1 bit 0 (pas de type)
   - 1 bit 0 (pas d'ID)
   - 1 bit 0 (pas de corps)

Pour la transmission du premier message de présence, le codage selon l'invention permet un gain de 153 bits (512-359), mais l'homme du métier comprendra que le gain devient très important pour la transmission des messages de présence subséquents (14 bits au lieu de 512).

L'Annexe 2 donne un autre exemple de codage selon l'invention et sa taille pour un message plus complexe. Il s'agit d'un message de texte pouvant être utilisé dans une application de messagerie instantanée.

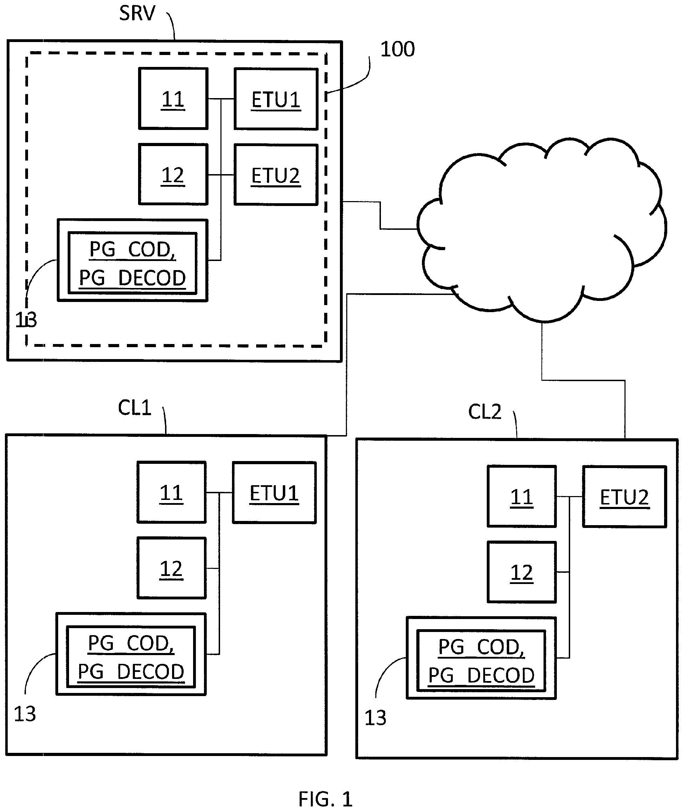

La figure 1 représente un système de collaboration conforme à l'invention.

Ce système comporte plus précisément un serveur SRV et 2 clients CL1, CL2 chacun de ces équipements étant un équipement de communication conforme à l'invention.

Chacun de ces équipements comporte un dispositif 100 conforme à l'invention apte à mettre en œuvre un procédé de codage et un procédé de décodage conformes à l'invention. Pour des raisons de clarté, seul celui du serveur SRV est référencé.

Dans l'exemple de réalisation décrit ici, ce dispositif 100 a l'architecture conventionnelle d'un ordinateur. Il comporte notamment un processeur 11, une mémoire vive de type RAM 12, une mémoire morte de type ROM 13, des moyens de communication non représentés.

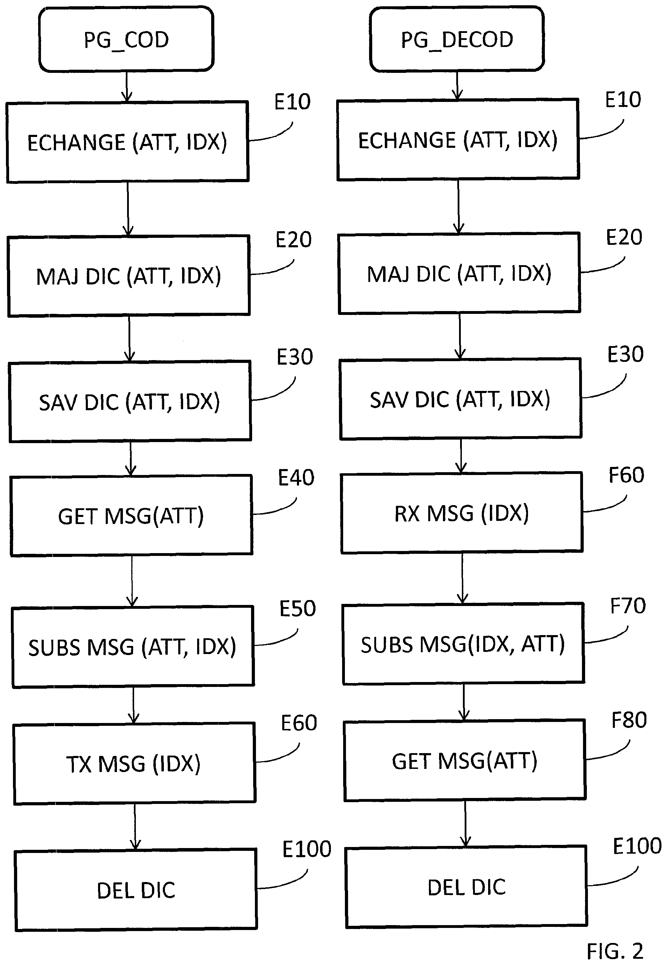

La mémoire morte de type ROM 13 constitue un support d'enregistrement conforme à l'invention lisible par le processeur 11. Ce support d'enregistrement mémorise deux programmes d'ordinateurs PG_COD (codage) et PG_DECOD (décodage) conformes à un mode particulier de réalisation de l'invention, et dont les principales étapes vont maintenant être décrites en référence à la figure 2.

En référence à la figure 2, nous allons détailler un exemple de mise en œuvre de réalisation de l'invention.

On suppose dans cet exemple que deux clients CL1, CL2 participent, sous le contrôle d'un serveur SRV, à une même session collaborative.

Dans cet exemple :
- le premier client CL1 a pour identifiant unique cl1@domaine;
- le deuxième client CL2 a pour identifiant unique cl2@domaine;
- le serveur SRV a pour identifiant unique srv@domaine.

Nous supposerons que le premier client CL1, le deuxième client CL2 et le serveur ont chacun un espace de travail réservé pour la session collaborative, d'identifiants uniques respectifs cl1@domaine/espace, cl2@domaine/espace et srv@domaine/espace.

Nous supposerons que le serveur SRV est en ligne et apte à accepter des requêtes des clients CL1, CL2 pour participer à la session collaborative.

Dans l'exemple décrit ici, on suppose que le premier client à vouloir se connecter au serveur SRV pour participer à la session de collaboration, après une phase d'initialisation et d'authentification connue en soi, est le client CL1.

Le client CL1 prépare à cet effet, au cours d'une étape E40, un message de présence M1, pour indiquer qu'il souhaite participer à la session de collaboration, du type :
M1: <presence from="cl1@domaine/espace"to="srv@domaine/espace"/>

Ce message nécessite deux identifiants, "cl1@domaine/espace" et "srv@domaine/espace", qui conformément à l'invention doivent être échangés avec le serveur SRV et mémorisés dans leur dictionnaire partagé ETU1.

Par conséquent, au cours d'une étape E10, antérieure à l'étape E40, le client CL1 et le serveur SRV mettent en œuvre une étape d'échange au cours de laquelle le client CL1 envoie au serveur SRV :
- l'attribut FROM cl1@domaine/espace associé à un index 0001; et
- l'attribut TO srv@domaine/espace associé à un index 0002.

Au cours d'une étape E20, le client CL1 et le serveur SRV mettent à jour chacun leur dictionnaire ETU1 avec les deux couples (attribut/index), à savoir (from=cll@domaine/espace, 0002) et (to=srv@domaine/espace, 0001).

Au cours d'une étape E30, le client CL1 et le serveur SRV sauvegardent chacun leur dictionnaire ETU1.

Conformément à l'invention, le client CL1 n'envoie pas au serveur SRV le message M1 qui a été préparé à l'étape E40, mais substitue, au cours d'une étape E50, chacun des attributs TO, FROM par son index dans le dictionnaire partagé.

Le message M2 résultat de cette substitution est par conséquent le message M2 : <0002 0001 >

Le client CL1 envoie le message M2 au serveur SRV qui le reçoit au cours d'une étape F60.

Puis au cours d'une étape F70, le serveur SRV substitue, dans le message M2, chacun des index 0001, 0002 du message M2 par l'attribut qui lui est associé dans le dictionnaire partagé ETU.

Le message M3 obtenu (étape F80) est identique au message M1 mentionné ci-dessus.

Le client CL1 et le serveur SRV se sont ainsi comportés comme un dispositif de codage et comme un dispositif de décodage au sens de l'invention.

On notera que dans une session de collaboration typique, le client CL1 envoie régulièrement, environ toutes les 2 ou 3s, un message de présence au serveur SRV.

Dans cet exemple, le codage du message M1 nécessite, mise à jour du dictionnaire comprise, 36 octets de données, chaque message de présence subséquent, nécessitant seulement 2 octets.

Nous supposerons maintenant que le deuxième client CL2 souhaite participer à la session collaborative, et qu'il prépare à cet effet un message de présence M4 du type :
M4 : <presence from="cl2@domaine/espace" to="srv@domaine/espace"/>

Comme décrit précédemment pour le premier client CL1, le deuxième client CL2 met en oeuvre une étape E10 d'échange avec le serveur SRV, au cours de laquelle le deuxième client CL2 envoie au serveur SRV :
- l'attribut FROM cl2@domaine/espace associé à l'index 0002; et
- l'attribut TO srv@domaine/espace associé à un index 0001.

Le deuxième client CL2 et le serveur SRV mettent à jour leur dictionnaire partagé ETU2 au cours d'une étape E20 et le sauvegardent au cours d'une étape E30.

Le codage du message M4 nécessite encore 36 octets de données.

On supposera dans cet exemple que le serveur SRV doit signaler la présence du deuxième client CL2 dans la session collaborative au premier client CL1.

Dans cette phase, le serveur SRV et le premier client CL1 se comportent respectivement comme un dispositif de codage et comme un dispositif de décodage au sens de l'invention.
- Le serveur SRV prépare donc le message M5 suivant au cours d'une étape E40 :
M5 : <presence from="cl2@domaine/espace" to="cl1@domaine/espace"/>

Le codage du message M5 nécessite l'envoi du nouvel attribut FROM cl2@domaine/espace au premier client CL1 associé à un nouvel index 0003 (étape E10).

Cette étape nécessite l'envoi de 19 octets.

Le serveur SRV et le premier client CL1 mettent à jour et sauvegardent leur dictionnaire partagé ETU1 au cours des étapes E20 et E30 déjà décrites.

De la même façon, le serveur SRV notifie le deuxième client CL2 de la présence du premier client CL1 par l'envoi d'un message de 19 octets également.

Chaque client CL1, CL2 peut ensuite envoyer régulièrement des messages subséquents de présence de 2 octets chacun au serveur SRV qui les notifie aux autres clients.

Ce principe peut être utilisé pour l'échange d'informations d'autres types.

A la fin de la session, chacun des équipements détruit le dictionnaire partagé au cours d'une étape E100.

### ANNEXE 1

```
 Class ETU {
      Bit(2) ETUType=0;
      Bit(8) ETUValue[till null];
      };
```

The Collaboration Information Units are as follows:

```
      Class CIU {
      Bit(2) CIUNature; /* 01:CIP, 10:CIM, 11:CIQ */
      Bit(3) CIUType; /* values depending on the preceeding nature
 field */
      Bit(1) TOFlag;
      If (TOFlag){
             Bit(maxETU) TOValue;
             }
      Bit(1) FROMFlag;
      If (FROMFlag){
             Bit(maxETU) FROMValue;
             }
      Bit(1) IDFlag;
      If (IDFlag){
             Bit(maxETU) IDValue;
            }
      Bit(1) BODYFlag;
      If (BODYFlag){
             BODYElement;
             }
 }
 BODYElement {
      Bit (maxETU) TAGName;
      While (Bit(1)ATBFlag){
            Bit (maxETU) ATBName;
            Bit (maxETU) ATBValue;
             }
      If (Bit(1)TEXT){
             Bit(8) TEXTBytes[till null];
             }
      While (Bit(1)MORE){
             BODYElement;
             }
 }
```

### ANNEXE 2

```
      < message
            from= "john@location/viewer"
            to= "host@location/scenario"
            type="groupchat"
            id="one">
             <x xmlns="ietf:urn:ns:jabber:client">
                   <data>bonjour</data>
            </x>
      </message>
      Codage
      Bits(2) 1 0 _MESSAGE;
      Bits(3) 0 1 1 _GROUPCHAT;
      Bit(1) 1 { Bits(etuMAX) FROM; }
      Bit(1) 1 { Bits(etuMAX) TO; }
      Bit(1) 1 { Bits(etuMAX) ID; }
      Bit(1)1{
      Bits(etuMAX) TAGName; /* x */
      Bit(1) 1 {
            Bits(etuMAX) ATBName; /* xmlns */
            Bits(etuMAX) ATBValue; /* urn:ietf:ns:jabber:client /*
            }
      Bit(1) 0 /* End of Attributs */
      Bit(1) 0 /* No Enclosed Text */
      Bit(1) 1 {
            Bits(etuMAX) TAGName; /* data */
            Bit(1) 0; /* No attributes */
            Bit(1) 1 { Bits(8) TEXT[till null]; } /* Bonjour */
            Bit(1) 0; /* No nested element */
            } /* /DATA */
      Bit(1) 0; /* No nested element */
      } /* /X */
      Bit(1) 0; /* No nested element */
      } /* /MESSAGE */
 Nombre de bits nécessaires
 2+3+1+n+1+n+1+n+
 1 +
       n+1+n+n+1+
       1 +
       1 +
             n +1
             1 + (8 * 8) +
             1 +
       1 +
 1
```

## Revendications

1. Procédé de codage sans perte de messages de collaboration conformes au protocole XMPP, ce procédé de codage étant mis en œuvre par un équipement émetteur, en communication bidirectionnelle avec au moins un équipement récepteur dans une session d'échange de contenus multimédia,
lesdits messages de collaboration étant :
- des messages d'énumération utilisés pour la mise à jour d'un dictionnaire partagé au cours de ladite session ;
- des messages CIP spécifiant un état de présence dudit équipement émetteur ;
- des messages CIM comportant des informations destinées audit au moins équipement récepteur,
- des messages CIQ comportant des métadonnées d'administration ou de contrôle d'un système de collaboration dans lequel ladite session est mise oeuvre
ce procédé comportant :
- au cours de ladite session, après la localisation de l'équipement émetteur et dudit au moins un équipement récepteur, au moins :
- une étape (E10) d'échange, avec ledit au moins un équipement récepteur, d'au moins un attribut d'un dit message de collaboration (CIU) susceptible d'être utilisé dans ladite session et d'un index associé à cet attribut, ledit au moins un attribut et son index étant utilisés par lesdits équipements pour mettre à jour ledit dictionnaire partagé (ETU) d'attributs indexés, ce dictionnaire étant mémorisé par chacun desdits équipements pendant toute la durée de la session, le contenu dudit dictionnaire augmentant au besoin pendant le déroulement de ladite session, lesdits messages d'énumération étant utilisés pour ledit échange des données du dictionnaire partagé ;
- une étape (E50) de substitution, dans un message de collaboration (CIU) destiné à être envoyé audit au moins un équipement récepteur, d'au moins un attribut par son index dans ledit dictionnaire partagé (ETU) et d'envoi de ce message de collaboration (CIU) audit au moins un équipement récepteur ; et
- une étape (E100) de destruction dudit dictionnaire partagé (ETU) à la fin de ladite session,
la taille dudit attribut étant supérieure à la taille de son index dans ledit dictionnaire partagé (ETU).

2. Procédé de décodage sans perte de messages de collaboration conformes au protocole XMPP, ce procédé de décodage étant mis en œuvre par un équipement récepteur, en communication bidirectionnelle avec au moins un équipement émetteur dans une session d'échange de contenu multimédia,
lesdits messages de collaboration étant :
- des messages d'énumération utilisés pour la mise à jour d'un dictionnaire partagé au cours de ladite session ;
- des messages CIP spécifiant un état de présence dudit équipement émetteur ;
- des messages CIM comportant des informations destinées audit au moins équipement récepteur,
- des messages CIQ comportant des métadonnées d'administration ou de contrôle d'un système de collaboration dans lequel ladite session est mise oeuvre
ce procédé comportant après la localisation de l'équipement émetteur et dudit au moins un équipement récepteur :
- au cours de ladite session, au moins :
- une étape (E10) d'échange, avec ledit au moins un équipement émetteur, d'au moins un attribut d'un dit message de collaboration (CIU) susceptible d'être utilisé dans ladite session et d'un index associé à cet attribut, ledit au moins un attribut et son index étant utilisés par lesdits équipements pour mettre à jour ledit dictionnaire partagé (ETU) d'attributs indexés, ce dictionnaire étant mémorisé par chacun desdits équipements pendant toute la durée de la session, lesdits messages d'énumération étant utilisés pour ledit échange des données du dictionnaire partagé ; et
- une étape (F60) de réception d'un dit message de collaboration (CIU) émis par un dit équipement émetteur comportant au moins un index ;
- une étape (F70) de substitution dudit au moins un index par l'attribut auquel il est associé dans ledit dictionnaire partagé (ETU) dans ledit message de collaboration (CIU) reçu dudit équipement émetteur ; et
- une étape (E100) de destruction dudit dictionnaire partagé (ETU) à la fin de ladite session,
la taille dudit attribut étant supérieure à la taille de son index dans ledit dictionnaire partagé (ETU).

3. Procédé selon la revendication 1 ou 2, **caractérisé en ce que** lesdits message de collaboration (CIU) comportent :
- un champ de deux bits (CIUNature) pour décrire la nature, CIP, CIM, CIQ du message de collaboration ; et pour les messages CIP, CIM et CIQ :
- un élément (CIUType) représentatif de la sémantique de ladite nature ; et
- un élément binaire représentatif de la présence ou non dudit attribut dans ledit message, suivi, lorsque ledit attribut est présent, par un corps (BODY) comportant l'index associé audit attribut dans ledit dictionnaire partagé (ETU).

4. Dispositif de codage sans perte de messages de collaboration conformes au protocole XMPP, ce dispositif pouvant être incorporé dans un équipement émetteur apte à établir une communication bidirectionnelle avec au moins un équipement récepteur dans une session d'échange de contenu multimédia,
lesdits messages de collaboration étant :
- des messages d'énumération utilisés pour la mise à jour d'un dictionnaire partagé au cours de ladite session ;
- des messages CIP spécifiant un état de présence dudit équipement émetteur ;
- des messages CIM comportant des informations destinées audit au moins équipement récepteur,
- des messages CIQ comportant des métadonnées d'administration ou de contrôle d'un système de collaboration dans lequel ladite session est mise oeuvre
ledit équipement émetteur et ledit au moins un équipement récepteur ayant été localisés, ce dispositif comportant :
- des moyens pour échanger avec ledit au moins un équipement récepteur, au cours de ladite session, au moins un attribut d'un message de collaboration (CIU) susceptible d'être utilisé dans ladite session et d'un index associé à cet attribut, ledit au moins un attribut et son index étant utilisés par lesdits équipements pour mettre à jour ledit dictionnaire partagé (ETU) d'attributs indexés, , lesdits messages d'énumération étant utilisés pour ledit échange des données du dictionnaire partagé ;
- des moyens pour mémoriser ledit dictionnaire partagé (ETU) pendant toute la durée de la session, le contenu dudit dictionnaire augmentant au besoin pendant le déroulement de ladite session ;
- des moyens de substitution, dans un message de collaboration (CIU) destiné à être envoyé audit au moins un équipement récepteur, d'au moins un attribut par son index dans ledit dictionnaire partagé (ETU) etdes moyens d'envoi de ce message (CIU) audit au moins un équipement récepteur ; et
- des moyens de destruction dudit dictionnaire partagé (ETU) à la fin de ladite session,
la taille dudit attribut étant supérieure à la taille de son index dans ledit dictionnaire partagé (ETU).

5. Dispositif de décodage sans perte de messages de collaboration conformes au protocole XMPP, , ce dispositif pouvant être incorporé dans un équipement récepteur apte à établir une communication bidirectionnelle avec au moins un équipement émetteur dans une session d'échange de contenu multimédia,
lesdits messages de collaboration étant :
- des messages d'énumération utilisés pour la mise à jour d'un dictionnaire partagé au cours de ladite session ;
- des messages CIP spécifiant un état de présence dudit équipement émetteur ;
- des messages CIM comportant des informations destinées audit au moins équipement récepteur,
- des messages CIQ comportant des métadonnées d'administration ou de contrôle d'un système de collaboration dans lequel ladite session est mise œuvre,
ledit équipement émetteur et ledit équipement récepteur ayant déjà été localisés, ce dispositif comportant :
- des moyens pour échanger avec ledit au moins un équipement émetteur, au cours de ladite session, au moins un attribut d'un dit message de collaboration (CIU) susceptible d'être utilisé dans ladite session et d'un index associé à cet attribut, ledit au moins un attribut et son index étant utilisés par lesdits équipements pour mettre à jour ledit dictionnaire partagé (ETU) d'attributs indexés, le contenu dudit dictionnaire augmentant au besoin pendant le déroulement de ladite session, lesdits messages d'énumération étant utilisés pour ledit échange des données du dictionnaire partagé ;
- des moyens de réception d'un message de collaboration (CIU) émis par un dit équipement émetteur comportant au moins un index ;
- des moyens de substitution, dudit au moins un index par l'attribut auquel il est associé dans ledit dictionnaire partagé (ETU) dans ledit message de collaboration (CIU) reçu dudit équipement émetteur ; et
- des moyens de destruction dudit dictionnaire partagé (ETU) à la fin de ladite session,
la taille dudit attribut étant supérieure à la taille de son index dans ledit dictionnaire partagé (ETU).

6. Dispositif de communication comportant un dispositif de codage selon la revendication 4 et un dispositif de décodage selon la revendication 5.

7. Programme d'ordinateur comportant des instructions pour l'exécution des étapes d'un procédé de codage et/ou d'un procédé de décodage selon l'une quelconque des revendications 1 à 3 lorsque ledit programme est exécuté par un ordinateur.

8. Support d'enregistrement lisible par un ordinateur sur lequel est enregistré un programme d'ordinateur comprenant des instructions pour l'exécution des étapes d'un procédé de codage et/ou d'un procédé de décodage selon l'une quelconque des revendications 1 à 3.

9. Equipement de communication comportant un dispositif selon l'une quelconque des revendications 4 à 6.

10. Système de collaboration comportant au moins :
- un équipement selon la revendication 9, cet équipement comportant un dispositif selon la revendication 4 ou selon la revendication 6 ; et
- un équipement selon la revendication 9, cet équipement comportant un dispositif selon la revendication 5 ou selon la revendication 6.

## Patentansprüche

1. Verfahren zum verlustfreien Kodieren von Kollaborationsnachrichten gemäß dem XMPP-Protokoll, wobei dieses Kodierverfahren von einer Sendeeinrichtung in bidirektionaler Kommunikation mit wenigstens einer Empfangseinrichtung in einer Sitzung zum Austausch von Multimediainhalten durchgeführt wird,
wobei die Kollaborationsnachrichten sind:
- Aufzählungsnachrichten, die zum Aktualisieren eines im Laufe der Sitzung gemeinsam genutzten Wörterbuchs verwendet werden,
- CIP-Nachrichten, die einen Anwesenheitszustand der Sendeeinrichtung spezifizieren,
- CIM-Nachrichten, die Informationen umfassen, welche für die wenigstens eine Empfangseinrichtung bestimmt sind,
- CIQ-Nachrichten, die Metadaten zum Verwalten oder Steuern eines Kollaborationssystems umfassen, in dem die Sitzung durchgeführt wird,
wobei dieses Verfahren
- im Laufe der Sitzung, nach der Lokalisierung der Sendeeinrichtung und der wenigstens einen Empfangseinrichtung, wenigstens umfasst:
- einen Schritt (E10) zum Austauschen wenigstens eines Attributs einer Kollaborationsnachricht (CIU), das geeignet ist, in der Sitzung verwendet zu werden, und eines diesem Attribut zugeordneten Index mit der wenigstens einen Empfangseinrichtung, wobei das wenigstens eine Attribut und sein Index von den Einrichtungen verwendet werden, um das gemeinsam genutzte Wörterbuch (ETU) von indizierten Attributen zu aktualisieren, wobei dieses Wörterbuch von jeder der Einrichtungen während der gesamten Dauer der Sitzung gespeichert wird, wobei der Inhalt des Wörterbuchs während des Ablaufs der Sitzung bei Bedarf zunimmt, wobei die Aufzählungsnachrichten für den Austausch der Daten des gemeinsam genutzten Wörterbuchs verwendet werden,
- einen Schritt (E50) zum Ersetzen von wenigstens einem Attribut durch seinen Index in dem gemeinsam genutzten Wörterbuch (ETU) in einer Kollaborationsnachricht (CIU), welche dazu bestimmt ist, an die wenigstens eine Empfangseinrichtung gesendet zu werden, und zum Senden dieser Kollaborationsnachricht (CIU) an die wenigstens eine Empfangseinrichtung, und
- einen Schritt (E100) zum Zerstören des gemeinsam genutzten Wörterbuchs (ETU) am Ende der Sitzung,
wobei die Größe des Attributs größer als die Größe seines Index in dem gemeinsam genutzten Wörterbuch (ETU) ist.

2. Verfahren zum verlustfreien Dekodieren von Kollaborationsnachrichten gemäß dem XMPP-Protokoll, wobei dieses Dekodierverfahren von einer Empfangseinrichtung in bidirektionaler Kommunikation mit wenigstens einer Sendeeinrichtung in einer Sitzung zum Austausch von Multimediainhalt durchgeführt wird,
wobei die Kollaborationsnachrichten sind:
- Aufzählungsnachrichten, die zum Aktualisieren eines im Laufe der Sitzung gemeinsam genutzten Wörterbuchs verwendet werden,
- CIP-Nachrichten, die einen Anwesenheitszustand der Sendeeinrichtung spezifizieren,
- CIM-Nachrichten, die Informationen umfassen, welche für die wenigstens eine Empfangseinrichtung bestimmt sind,
- CIQ-Nachrichten, die Metadaten zum Verwalten oder Steuern eines Kollaborationssystems umfassen, in dem die Sitzung durchgeführt wird,
wobei dieses Verfahren nach der Lokalisierung der Sendeeinrichtung und der wenigstens einen Empfangseinrichtung
- im Laufe der Sitzung, nach der Lokalisierung der Sendeeinrichtung und der wenigstens einen Empfangseinrichtung, wenigstens umfasst:
- einen Schritt (E10) zum Austauschen wenigstens eines Attributs einer Kollaborationsnachricht (CIU), das geeignet ist, in der Sitzung verwendet zu werden, und eines diesem Attribut zugeordneten Index mit der wenigstens einen Sendeeinrichtung, wobei das wenigstens eine Attribut und sein Index von den Einrichtungen verwendet werden, um das gemeinsam genutzte Wörterbuch (ETU) von indizierten Attributen zu aktualisieren, wobei dieses Wörterbuch von jeder der Einrichtungen während der gesamten Dauer der Sitzung gespeichert wird, wobei die Aufzählungsnachrichten für den Austausch der Daten des gemeinsam genutzten Wörterbuchs verwendet werden, und
- einen Schritt (F60) zum Empfangen einer von einer Sendeeinrichtung gesendeten Kollaborationsnachricht (CIU) mit wenigstens einem Index,
- einen Schritt (F70) zum Ersetzen des wenigstens einen Index durch das Attribut, dem er in dem gemeinsam genutzten Wörterbuch (ETU) zugeordnet ist, in der Kollaborationsnachricht (CIU), die von der Sendeeinrichtung empfangen wird, und
- einen Schritt (E100) zum Zerstören des gemeinsam genutzten Wörterbuchs (ETU) am Ende der Sitzung,
wobei die Größe des Attributs größer als die Größe seines Index in dem gemeinsam genutzten Wörterbuch (ETU) ist.

3. Verfahren nach Anspruch 1 oder 2, **dadurch gekennzeichnet, dass** die Kollaborationsnachrichten (CIU) umfassen:
- ein Zwei-Bit-Feld (CIUNature), um die Art, CIP, CIM, CIQ, der Kollaborationsnachricht zu beschreiben; und für die CIP-, CIM-, CIQ-Nachrichten:
- ein Element (CIUType), das für die Semantik der Art repräsentativ ist, und
- ein binäres Element, das für das Vorhandensein oder Fehlen des Attributs in der Nachricht repräsentativ ist, gefolgt von einem Körper (BODY), der den dem Attribut in dem gemeinsam genutzten Wörterbuch (ETU) zugeordneten Index umfasst, wenn das Attribut vorhanden ist.

4. Vorrichtung zum verlustfreien Kodieren von Kollaborationsnachrichten gemäß dem XMPP-Protokoll, wobei diese Vorrichtung in eine Sendeeinrichtung integriert werden kann, welche geeignet ist, eine bidirektionale Kommunikation mit wenigstens einer Empfangseinrichtung in einer Sitzung zum Austausch von Multimediainhalt herzustellen,
wobei die Kollaborationsnachrichten sind:
- Aufzählungsnachrichten, die zum Aktualisieren eines im Laufe der Sitzung gemeinsam genutzten Wörterbuchs verwendet werden,
- CIP-Nachrichten, die einen Anwesenheitszustand der Sendeeinrichtung spezifizieren,
- CIM-Nachrichten, die Informationen umfassen, welche für die wenigstens eine Empfangseinrichtung bestimmt sind,
- CIQ-Nachrichten, die Metadaten zum Verwalten oder Steuern eines Kollaborationssystems umfassen, in dem die Sitzung durchgeführt wird,
wobei die Sendeeinrichtung und die wenigstens eine Empfangseinrichtung lokalisiert worden sind, wobei diese Vorrichtung umfasst:
- Mittel zum Austauschen wenigstens eines Attributs einer Kollaborationsnachricht (CIU), das geeignet ist, in der Sitzung verwendet zu werden, und eines diesem Attribut zugeordneten Index mit der wenigstens einen Empfangseinrichtung im Laufe der Sitzung, wobei das wenigstens eine Attribut und sein Index von den Einrichtungen verwendet werden, um das gemeinsam genutzte Wörterbuch (ETU) von indizierten Attributen zu aktualisieren, wobei die Aufzählungsnachrichten für den Austausch der Daten des gemeinsam genutzten Wörterbuchs verwendet werden,
- Mittel zum Speichern des gemeinsam genutzten Wörterbuchs (ETU) während der gesamten Dauer der Sitzung, wobei der Inhalt des Wörterbuchs während des Ablaufs der Sitzung bei Bedarf zunimmt,
- Mittel zum Ersetzen von wenigstens einem Attribut durch seinen Index in dem gemeinsam genutzten Wörterbuch (ETU) in einer Kollaborationsnachricht (CIU), welche dazu bestimmt ist, an die wenigstens eine Empfangseinrichtung gesendet zu werden, und Mittel zum Senden dieser Nachricht (CIU) an die wenigstens eine Empfangseinrichtung, und
- Mittel zum Zerstören des gemeinsam genutzten Wörterbuchs (ETU) am Ende der Sitzung,
wobei die Größe des Attributs größer als die Größe seines Index in dem gemeinsam genutzten Wörterbuch (ETU) ist.

5. Vorrichtung zum verlustfreien Dekodieren von Kollaborationsnachrichten gemäß dem XMPP-Protokoll, wobei diese Vorrichtung in eine Empfangseinrichtung integriert werden kann, welche geeignet ist, eine bidirektionale Kommunikation mit wenigstens einer Sendeeinrichtung in einer Sitzung zum Austausch von Multimediainhalt herzustellen,
wobei die Kollaborationsnachrichten sind:
- Aufzählungsnachrichten, die zum Aktualisieren eines im Laufe der Sitzung gemeinsam genutzten Wörterbuchs verwendet werden,
- CIP-Nachrichten, die einen Anwesenheitszustand der Sendeeinrichtung spezifizieren,
- CIM-Nachrichten, die Informationen umfassen, welche für die wenigstens eine Empfangseinrichtung bestimmt sind,
- CIQ-Nachrichten, die Metadaten zum Verwalten oder Steuern eines Kollaborationssystems umfassen, in dem die Sitzung durchgeführt wird,
wobei die Sendeeinrichtung und die Empfangseinrichtung bereits lokalisiert worden sind, wobei diese Vorrichtung umfasst:
- Mittel zum Austauschen wenigstens eines Attributs einer Kollaborationsnachricht (CIU), das geeignet ist, in der Sitzung verwendet zu werden, und eines diesem Attribut zugeordneten Index mit der wenigstens einen Sendeeinrichtung im Laufe der Sitzung, wobei das wenigstens eine Attribut und sein Index von den Einrichtungen verwendet werden, um das gemeinsam genutzte Wörterbuch (ETU) von indizierten Attributen zu aktualisieren, wobei der Inhalt des Wörterbuchs während des Ablaufs der Sitzung nach Bedarf zunimmt, wobei die Aufzählungsnachrichten für den Austausch der Daten des gemeinsam genutzten Wörterbuchs verwendet werden,
- Mittel zum Empfangen einer von einer Sendeeinrichtung gesendeten Kollaborationsnachricht (CIU) mit wenigstens einem Index,
- Mittel zum Ersetzen des wenigstens einen Index durch das Attribut, dem er in dem gemeinsam genutzten Wörterbuch (ETU) zugeordnet ist, in der von der Sendeeinrichtung empfangenen Kollaborationsnachricht (CIU), und
- Mittel zum Zerstören des gemeinsam genutzten Wörterbuchs (ETU) am Ende der Sitzung,
wobei die Größe des Attributs größer als die Größe seines Index in dem gemeinsam genutzten Wörterbuch (ETU) ist.

6. Kommunikationsvorrichtung, die eine Kodiervorrichtung nach Anspruch 4 und eine Dekodiervorrichtung nach Anspruch 5 umfasst.

7. Computerprogramm, umfassend Befehle für die Durchführung der Schritte eines Kodierverfahrens und/oder eines Dekodierverfahrens nach einem der Ansprüche 1 bis 3, wenn das Programm von einem Computer ausgeführt wird.

8. Durch einen Computer lesbarer Aufzeichnungsträger, auf dem ein Computerprogramm gespeichert ist, das Befehle für die Durchführung der Schritte eines Kodierverfahrens und/oder eines Dekodierverfahrens nach einem der Ansprüche 1 bis 3 umfasst.

9. Kommunikationsrichtung, die eine Vorrichtung nach einem der Ansprüche 4 bis 6 umfasst.

10. Kollaborationssystem, das wenigstens umfasst:
- eine Einrichtung nach Anspruch 9, wobei diese Einrichtung eine Vorrichtung nach Anspruch 4 oder nach Anspruch 6 umfasst, und
- eine Einrichtung nach Anspruch 9, wobei diese Einrichtung eine Vorrichtung nach Anspruch 5 oder nach Anspruch 6 umfasst.

## Claims

1. A method for lossless encoding of collaboration messages compliant with the XMPP protocol, this encoding method being implemented by one transmitter equipment, in bidirectional communication with at least one receiver equipment in a multimedia content exchange session,
said collaboration messages being:
- enumeration messages used for the update of a shared dictionary during said session;
- CIP messages specifying a state of presence of said transmitter equipment;
- CIM messages including information intended for said at least one receiver equipment;
- CIQ messages including administration or control metadata of a collaboration system in which said session is implemented;
this method including:
- during said session, after location of the transmitter equipment and of said at least one receiver equipment, at least:
• a step (E10) of exchanging, with said at least one receiver equipment, at least one attribute of one said collaboration message (CIU) capable of being used in said session and an index associated with this attribute, said at least one attribute and its index being used by said equipment to update said shared dictionary (ETU) of indexed attributes, this dictionary being stored by each of said equipment throughout the duration of the session, the content of said dictionary increasing as needed during the course of said session, said enumeration messages being used for said exchange of the data of the shared dictionary;
• a step (E50) of substituting, in a collaboration message (CIU) intended to be sent to said at least one receiver equipment, at least one attribute by its index in said shared dictionary (ETU) and sending this collaboration message (CIU) to at least one receiver equipment; and
- a step (E100) of destroying said shared dictionary (ETU) at the end of said session,
the size of said attribute being greater than the size of its index in said shared dictionary (ETU).

2. The method for lossless decoding of collaboration messages compliant with the XMPP protocol, this decoding method being implemented by one receiver equipment, in bidirectional communication with at least one transmitter equipment in a multimedia content exchange session,
said collaboration messages being:
- enumeration messages used for the update of a shared dictionary during said session;
- CIP messages specifying a state of presence of said transmitter equipment;
- CIM messages including information intended for said at least one receiver equipment;
- CIQ messages including administration or control metadata of a collaboration system in which said session is implemented,
this method including after location of the transmitter equipment and of said at least one receiver equipment:
- during said session, at least:
• a step (E10) of exchanging, with said at least one transmitter equipment, at least one attribute of one said collaboration message (CIU) capable of being used in said session and an index associated with this attribute, said at least one attribute and its index being used by said equipment to update said shared dictionary (ETU) of indexed attributes, this dictionary being stored by each of said equipment throughout the duration of the session, said enumeration messages being used for said exchange of the data of the shared dictionary; and
• a step (F60) of receiving one said collaboration message (CIU) issued by one said transmitter equipment including at least one index;
• a step (F70) of substituting said at least one index by the attribute with which it is associated in said shared dictionary (ETU) in said collaboration message (CIU) received from said transmitter equipment; and
- a step (E100) of destroying said shared dictionary (ETU) at the end of said session,
the size of said attribute being greater than the size of its index in said shared dictionary (ETU).

3. The method according to claim 1 or 2, **characterized in that** said collaboration messages (CIU) include:
- a two-bit field (CIUNature) to describe the nature, CIP, CIM, CIQ of the collaboration message; and for CIP, CIM and CIQ messages:
- an element (CIUType) representative of the semantics of said nature; and
- a binary element representative of the presence or absence of said attribute in said message, followed, when said attribute is present, by a body (BODY) including the index associated with said attribute in said shared dictionary (ETU).

4. A device for lossless encoding of collaboration messages compliant with the XMPP protocol, this device being able to be incorporated into one transmitter equipment able to establish bidirectional communication with at least one receiver equipment in a multimedia content exchange session,
said collaboration messages being:
- enumeration messages used for the update of a shared dictionary during said session;
- CIP messages specifying a state of presence of said transmitter equipment;
- CIM messages including information intended for said at least one receiver equipment;
- CIQ messages including administration or control metadata of a collaboration system in which said session is implemented,
said transmitter equipment and said at least one receiver equipment having been located, this device including:
- means for exchanging, with said at least one receiver equipment, during said session, at least one attribute of a collaboration message (CIU) capable of being used in said session and an index associated with this attribute, said at least one attribute and its index being used by said equipment to update said shared dictionary (ETU) of indexed attributes, said enumeration messages being used for said exchange of the data of the shared dictionary;
- means for storing said shared dictionary (ETU) throughout the duration of the session, the content of said dictionary increasing as needed during the course of said session;
- means for substituting, in a collaboration message (CIU) intended to be sent to said at least one receiver equipment, at least one attribute by its index in said shared dictionary (ETU) and means for sending this message (CIU) to at least one receiver equipment; and
- means for destroying said shared dictionary (ETU) at the end of said session,
the size of said attribute being greater than the size of its index in said shared dictionary (ETU).

5. The device for lossless decoding of collaboration messages compliant with the XMPP protocol, this device being able to be incorporated into one receiver equipment able to establish a bidirectional communication with at least one transmitter equipment in a multimedia content exchange session,
said collaboration messages being:
- enumeration messages used for the update of a shared dictionary during said session;
- CIP messages specifying a state of presence of said transmitter equipment;
- CIM messages including information intended for said at least one receiver equipment,
- CIQ messages including administration or control metadata of a collaboration system in which said session is implemented,
said transmitter equipment and said receiver equipment having already been located, this device including:
- means for exchanging, with said at least one transmitter equipment, during said session, at least one attribute of one said collaboration message (CIU) capable of being used in said session and an index associated with this attribute, said at least one attribute and its index being used by said equipment to update said shared dictionary (ETU) of indexed attributes, the content of said dictionary increasing as needed during the course of said session, said enumeration messages being used for said exchange of the data of the shared dictionary;
- means for receiving a collaboration message (CIU) issued by one said transmitter equipment including at least one index;
- means for substituting said at least one index by the attribute with which it is associated in said shared dictionary (ETU) in said collaboration message (CIU) received from said transmitter equipment; and
- means for destroying said shared dictionary (ETU) at the end of said session,
the size of said attribute being greater than the size of its index in said shared dictionary (ETU).

6. A communication device including an encoding device according to claim 4 and a decoding device according to claim 5.

7. A computer program including instructions for the execution of the steps of an encoding method and/or of a decoding method according to any one of claims 1 to 3 when said program is executed by a computer.

8. A recording medium readable by a computer on which a computer program is recorded comprising instructions for the execution of the steps of an encoding method and/or of a decoding method according to any one of the claims 1 to 3.

9. One communication equipment including a device according to any one of claims 4 to 6.

10. A collaboration system including at least:
- one equipment according to claim 9, this equipment including a device according to claim 4 or according to claim 6; and
- one equipment according to claim 9, this equipment including a device according to claim 5 or according to claim 6.
